## Europäisches Patentamt
## European Patent Office
## Office européen des brevets

(11) Veröffentlichungsnummer: **0 109 644**

**A2**

(12) # EUROPÄISCHE PATENTANMELDUNG

(21) Anmeldenummer: 83111391.5

(51) Int. Cl.³: **G 01 R 21/08**

(22) Anmeldetag: 15.11.83

(30) Priorität: 23.11.82 DE 3243258
27.07.83 DE 3327023

(43) Veröffentlichungstag der Anmeldung:
30.05.84 Patentblatt 84/22

(84) Benannte Vertragsstaaten:
AT BE CH DE FR GB IT LI NL SE

(71) Anmelder: **Rafi GmbH & Co Elektrotechnische
Spezialfabrik
Ravensburger Strasse 128-134
D-7981 Berg bei Ravensburg(DE)**

(72) Erfinder: **Baier, Paul Walter, Prof. Dr.-Ing.
Burgunderstrasse 6
D-6750 Kaiserslautern(DE)**

(72) Erfinder: **Dostert, Klaus, Dr.-Ing.
Bergstrasse 3
D-6751 Krickenbach(DE)**

(74) Vertreter: **Engelhardt, Guido, Dipl.-Ing.
Montafonstrasse 35 Postfach 1350
D-7990 Friedrichshafen 1(DE)**

(54) **Messgerät.**

(57) Bei einem Meßgerät (1) zur Bestimmung der Leistung und des Energieverbrauchs eines Verbrauchers (3) elektrischer Energie ist in dessen Stromkreis ein einen Hallgenerator aufweisender Meßwertaufnehmer (11) eingeschaltet, dessen als Produkt aus Spannung und Strom gebildete Ausgangsspannung einem spannungsgesteuerten Oszillator (14) als Steuerspannung zugeführt wird. Des weiteren ist an den spannungsgesteuerten Oszillator (14) eine Recheneinheit (16) zur Auswertung der Ausgangsfrequenz angeschlossen.

Auf diese Weise ist es möglich, mit einfachen Mitteln und ohne daß eine Umschaltung erforderlich ist, gleichzeitig die momentane Leistungsaufnahme und den Energieverbrauch des Verbrauchers (3) zu bestimmen.

EP 0 109 644 A2

./...

FIG. 1

DIPL.-ING. GUIDO ENGELHARDT PATENTANWALT 0109644

7990 Friedrichshafen

Rafi GmbH & Co
Elektrotechnische Spezialfabrik
7981 Berg bei Ravensburg

## Meßgerät

Die Erfindung bezieht sich auf ein Meßgerät zur Bestimmung der Leistungsaufnahme und des Energieverbrauches eines Verbrauchers elektrischer Energie.

An einem zweipoligen elektrischen Verbraucher, der mit einer elektrischen Spannung u(t) gespeist wird, kann die von dem Verbraucher aufgenommene momentane Leistung p(t) bestimmt werden, indem man den Momentanwert u(t) der elektrischen Spannung an den Verbraucherklemmen mit dem Momentanwert i(t) des elektrischen Stromes, der durch den Verbraucher fließt, multipliziert. Es ist

$$p(t) = u(t) \cdot i(t). \qquad (1)$$

Die von dem Verbraucher aufgenommene elektrische Energie W in einem Zeitintervall der Dauer T erhält man durch Integration über die momentane Leistung bezüglich der Zeit, somit

$$W = \int_{0}^{T} u(t) \cdot i(t) \, dt. \qquad (2)$$

./.

0109644

Dieses Meßprinzip für den Verbrauch elektrischer Energie ist in den meisten heute gebräuchlichen Stromverbrauchsmessern realisiert, die entweder elektromechanisch, z.B. nach dem Wirbelstromprinzip, oder elektronisch arbeiten. Die elektronischen Stromverbrauchsmeßgeräte unterscheiden sich im wesentlichen hinsichtlich der Ausführung der Muliplikation $u(t) \cdot i(t)$. Es sind drei Varianten gebräuchlich:

a) Einsatz eines Vierquadranten-Analogmultiplizierers,

b) Verwendung eines Hallgenerators als Mulitplizierer,

c) Analog/Digital-Wandlung der Eingangsgrößen und digitale Multiplikation.

Bildet man hierbei in einem Zeitintervall der Dauer $\Delta T$ den zeitlichen Mittelwert der momentanen Leistung $p(t)$ nach (1), so erhält man die mittlere Leistung

$$ P = \frac{1}{\Delta T} \int_{0}^{\Delta T} u(t) \cdot i(t) \, dt. \qquad (3) $$

Bei stationären Vorgängen ist die mittlere Leistung P konstant und entspricht der Wirkleistung, die der Verbraucher aufnimmt. Wesentliches Merkmal der Leistungsbestimmung nach (3) ist wiederum die Multiplikation der Größen $u(t) \cdot i(t)$, die elektromechanisch, z.B. mittels eines Wattmeters, oder elektronisch nach einer der drei obengenannten Varianten a, b und c erfolgen kann. Im elektromechanischen Wattmeter erfolgt die Mittelwertbildung durch die Trägheit des Meßwerks. Bei den elektronischen Varianten a und b kann ein Tiefpaß mit geeignet gewählter Grenzfrequenz zur Mittelwertbildung an den Multipliziererausgang geschaltet werden; bei der Variante c kann die Mittelwertbildung in einer digitalen Rechenschaltung erfolgen.

Die bisher bekannten Ausführungen elektrischer Leistungs-
und Energieverbrauchsmeßgeräte sind jedoch mit folgenden
Nachteilen behaftet:

## Elektromechanische Leistungs- und Energieverbrauchsmeßgeräte

### Wirbelstromzähler
- zeigen nur Energieverbrauch an (nicht Leistung),
- können nur vom Fachmann angeschlossen werden,
- erfordern eine bestimmte Betriebslage,
- sind relativ unhandlich und teuer,
- sind nicht rücksetzbar in Nullstellung,
- unterliegen mechanischem Verschleiß und erfordern Wartung.

### Elektromechanische Wattmeter
- zeigen nur Leistung an (nicht Energieverbrauch),
- können nur vom Fachmann angeschlossen werden,
- erfordern stets Anpassung des Meßbereichs an den Verbraucher.

## Elektronische Leistungs- und Energieverbrauchsmeßgeräte

### Geräte mit Vierquadranten-Analogmultiplizierer
- sind nur vom Fachmann anschließbar,
- erfordern Meßbereichsumschaltung,
- sind elektronisch aufwendig und teuer,
- erfordern hohen Abgleichaufwand bei der Herstellung.

### Geräte mit Hallmultiplikation
- existieren nicht in einer vom Nichtfachmann
  handhabbaren Ausführung,
- erfordern Anpassung des Meßbereichs an den Verbraucher,
- es gibt keine Ausführungen mit gleichzeitiger Leistungs-
  und Energieverbrauchsmeßmöglichkeit.

Geräte mit digitaler Multiplikation

- erfordern hochauflösende Analog/Digital-Wandler für gute Genauigkeit,
- erfordern Meßbereichsumschaltung,
- sind nur vom Fachmann handhabbar,
- sind elektronisch aufwendig und teuer.

Aufgabe der Erfindung ist es demnach, ein Meßgerät zu schaffen, mittels dem die momentane Leistungsaufnahme und der Energieverbrauch eines an einen Stromkreis angeschlossenen Verrauchers gleichzeitig meßbar sind und das äußerst einfach in der Handhabung ist. Des weiteren soll das Meßgerät wirtschaftlich herzustellen sein und keine Meßbereichsumschaltung erfordern, auch soll das Meßgerät eine handliche Größe aufweisen und nach Anschluß an den Stromkreis des Verbrauchers sofort betriebsbereit sein.

Gemäß der Erfindung wird dies dadurch erreicht, daß in den Stromkreis des Verbrauchers ein einen Hallgenerator enthaltender, eine Ausgangsspannung als Produkt aus Spannung und Strom erzeugender Meßwertaufnehmer einschaltbar ist, in dem in Abhängigkeit von dem leistungsbestimmenden Strom ein magnetisches Induktionsfeld am Ort des Hallgenerators erzeugbar ist, wobei der Hallgenerator einen der leistungsbestimmenden Spannung entsprechenden Steuerstrom erhält, daß an dem Meßwertaufnehmer ein spannungsgesteuerter Oszillator angeschlossen ist, dem als Steuerspannung die Ausgangsspannung des Hallgenerators zuführbar ist, und daß der Oszillator mit einer Recheneinheit zur Auswertung der Ausgangsfrequenz verbunden ist.

./.

Wird ein Verbraucher gleichzeitig aus mehreren Stromquellen (Gleichstrom- oder Wechselstromquellen oder einem n-phasigen Wechselstromsystem, mit n = 1,2,3...) gespeist, ist pro Stromquelle ein Meßwertaufnehmer vorzusehen und die Ausgangsspannungen der Hallgeneratoren sind in einer Summiereinrichtung aufzusummieren und das Summensignal ist dem spannungsgesteuerten Oszillator zuzuführen.

Zweckmäßig ist es ferner, dem spannungsgesteuerten Oszillator einen Verstärker zuzuordnen und an den spannungsgesteuerten Oszillator einen Frequenzteiler anzuschließen, der mit der Recheneinheit in Verbindung steht.

Ein Teil der Recheneinheit ist in vorteilhafter Weise als elektronischer löschbarer Impulszähler auszubilden, mittels dem die Schwingungszahl des spannungsgesteuerten Oszillators aufsummierbar und dessen Zählerstand ein Maß für die verbrauchte Energie ist.

Des weiteren sollte ein Zähler in der Recheneinheit mittels einer zugeordneten Rücksetzeinrichtung periodisch löschbar sein, wobei der Zählerstand unmittelbar vor dem Löschvorgang ein Maß für die Leistungsaufnahme des Verbrauchers ist.

Angebracht ist es ferner, die Recheneinheit mit einer Anzeigeeinheit zur Darstellung der jeweiligen Zählerstände zu versehen und als Recheneinheit einen Mikroprozessor zu verwenden. Die Recheneinheit kann aber auch teilweise in Form mechanischer Zähler ausgebildet werden.

Des weiteren sollte die Recheneinheit mit einer bei Ausfall des zu messenden Stromkreises selbsttätig zuschaltbaren unabhängigen Stromquelle, mit einer Zeitschalteinrichtung und/oder einer elektrischen optischen oder akustischen, vorzugsweise einstellbaren Signaleinrichtung ausgestattet sein.

./.

Das gemäß der Erfindung ausgebildete Meßgerät ist nicht nur sehr einfach in seinem Aufbau und wirtschaftlich zu fertigen, da dieses weitgehend aus handelsüblichen Bauteilen zusammenzusetzen ist, sondern auch sehr einfach in der Handhabung und ermöglicht vor allem eine gleichzeitige Messung der momentanen Leistungsaufnahme und des Energieverbrauchs eines elektrischen Verbrauchers. In dem in den Stromkreis des Verbrauchers eingeschalteten Meßwertaufnehmer wird nämlich mittels eines Hallgenerators eine Ausgangsspannung erzeugt, die das Produkt aus der leistungsbestimmenden Spannung und dem leistungsbestimmenden Strom, die dem Verbraucher zugeführt werden, darstellt. Und diese Ausgangsspannung wird mittels eines spannungsgesteuerten Oszillators derart umgewandelt, daß mit Hilfe der an diesen angeschlossenen Recheneinheit der Energieverbrauch und die Leistungsaufnahme des Verbrauchers erkennbar sind.

Das erfindungsgemäß ausgebildete Meßgerät kann z.B. mittels eines Netzkabels mit angeschlossenem Schukostecker in jeder Netzsteckdose eingesteckt werden und ist sofort betriebsbereit. Die Leistungs- und Energieverbrauchsmessung des angeschlossenen Verbrauchers erfolgt elektronisch mit Hilfe eines Hallgenerators als Multiplizierer. Durch geeignete analoge Aufbereitung der Multipliziersignale und des -ausgangssignals und durch dessen Umsetzung in Rechteckschwingungen im spannungsgesteuerten Oszillator und anschließende digitale Verarbeitung mit Hilfe einer vorzugsweise als Ein-Chip-Mikroprozessor ausgebildeten Recheneinheit wird erreicht, daß

./.

jegliche Meßbereichsumschaltungen entfallen können. Mittels einer an die Recheneinheit angeschlossenen Digitalanzeige kann wahlweise die Leistungsaufnahme des angeschlossenen Vebrauchers in Watt oder die verbrauchte Energie seit dem Anschluß an das Stromnetz bzw. nach Drücken einer Rücksetztaste in kWh dargestellt werden.

Bei äußerst einfacher Handhabung kann somit die Leistungsaufnahme und der Energieverbrauch eines angeschlossenen elektrischen Verbrauchers gemessen und kontrolliert werden. Typische Anwendungsfälle sind z.B. im Haushalt die Erfassung des Energieverbrauchs eines Waschzyklusses der Waschmaschine oder der Spülmaschine oder die Kontrolle des Energieverbrauchs von Kühl- oder Gefriergeräten in einem bestimmten Zeitraum. Die Überprüfung älterer Geräte hinsichtlich des Energieverbrauchs ist besonders ratsam, da dessen Kontrolle sowie die Messung der Leistungsaufnahme das Auffinden von fehlerhaften Geräten, die einen erhöhten Energieverbrauch aufweisen, der unter Umständen jahrelang unentdeckt bleibt, ermöglichen. Beispielsweise können Wärmeisolationsschäden an Kühl- und Gefriergeräten auftreten. Auch Schäden an stark beanspruchten beweglichen netzbetriebenen Elektrogeräten, die eine erhöhte Fehlerrate zur Folge haben, z.B. Wicklungsschäden an Handschleif- und -bohrmaschinen können mit Hilfe des vorschlagsgemäß ausgebildeten Meßgerätes leicht ermittelt werden. Solche Schäden führen im allgemeinen zu erhöhtem Energieverbrauch, so daß eine regelmäßige Kontrolle auch hier zur Energieeinsparung beiträgt. Die Kontrolle des Energieverbrauchs kann auch als Basis für den energiekostenbewußten Einsatz von nicht defekten elektrischen Geräten dienen. Beispielsweise kann man durch eine solche Kontrolle feststellen, inwieweit durch Inkaufnahme einer etwas höheren Innentemperatur die Energiekosten eines Kühlschrankes verringert werden können.

Bei einem sehr geringen Eigenverbrauch ermöglicht das gemäß der Erfindung ausgebildete Meßgerät eine äußerst genaue Messung, ist, da nur ein Meßpunkt erforderlich, einfach zu eichen und wirkt nicht auf den Verbraucher zurück. Des weiteren werden durch eine Mittelwertbildung Störeinflüsse der Netzspannung auf die Meßwerte weitgehend kompensiert. Und da keine Meßbereichsumschaltungen und keine sonstigen besonderen Vorkehrungen zur Inbetriebnahme des Meßgerätes notwendig sind, ist dieses nahezu von jedermann leicht zu verwenden.

Oftmals ist es jedoch nicht ausreichend, nur die Wirkleistungsaufnahme und den Wirkenergieverbrauch eines elektrischen Gerätes zu bstimmen, vielfach ist es vielmehr erforderlich, auch andere Leistungsgrößen eines Verbrauchers, wie z. B. die Blindleistung oder die Scheinleistung zu kennen, um bei Überlastung eines Leitungsnetzes entsprechend reagieren zu können.

Es ist daher eine weitere Aufgabe der Erfindung, das Meßgerät in der Weise zu verbessern, daß mittels diesem nicht nur die Wirkleistung und die Wirkenergie eines Verbrauchers auf einfache Weise zu bestimmen sind, sondern mit dem wahlweise alle Kenngrößen eines Verbrauchers leicht ermittelt werden können, um beispielsweise die Belastung eines Netzes zu steuern oder die Querschnitte von Stromleitungen entsprechend zu bemessen. Der dazu erforderliche Bauaufwand soll gering gehalten werden, auch soll das Gerät einfach zu handhaben sein, aber dennoch eine hohe Zuverlässigkeit aufweisen.

Dies wird nach einer Weiterbildung dadurch erreicht, daß der Meßwertaufnehmer mit einem zweiten Hall-Generator versehen ist, der dem gleichen Magnetfeld wie der erste Hall-Generator aufgesetzt ist und der einen Steuerstrom erhält, der mittels eines Phasenschiebers gegenüber der leistungsbestimmenden Spannung zur Ermittlung der Blindleistung phasenverschoben ist, und daß der zweite Hall-Generator über einen weiteren Oszillator mit der Recheneinheit verbunden ist.

Das Magnetfeld des Meßwertaufnehmers wird somit aufgrund der vorgesehenen Ausgestaltung des Meßwertaufnehmers zweifach genutzt und die beiden Hall-Generatoren sind derart eingebaut, daß die Stärke des magnetischen Feldes am Ort dieser Sensoren dem Strom des angeschlossenen Verbrauchers entspricht. Der Mittelwert der Ausgangsspannung eines dieser Hall-Generatoren entspricht hierbei der vom Verbraucher aufgenommenen Wirkleistung, der Mittelwert der Ausgangsspannung des zweiten Hall-Generators dagegen der vom Verbraucher aufgenommenen Blindleistung. Der Steuerstrom des Wirkleistungs-Hall-Generators ist somit in Phase und proportional zur Verbraucherspannung, während der Steuerstrom des Blindleistungs-Hall-Generators durch eine Phasenschieberanordnung z. B. um 90$^{\circ}$ gegenüber der Verbraucherspannung verschoben wird und zu dieser proportional ist. Anhand des Vorzeichens des Mittelwertes der Ausgangsspannung des Blindleistungs-Hall-Generators kann entschieden werden, ob kapazitive oder induktive Blindleistung vorliegt.

Aus dem Vorzeichen der Mittelwerte der Ausgangsspannung des Wirkleistungs-Hall-Generators ist ersichtlich, in welcher Richtung der Leistungs- bzw. Energiefluß gerichtet ist. Das Meßverfahren ist für bidirektionalen Leistungs- bzw. Energiefluß geeignet, h. h., z. B. für den Fall, daß ein Motor als Verbraucher Leistung aufnimmt und auch für den Fall, daß der angeschlossene Motor mechanisch angetrieben wird und Leistung ins Netz zurückliefert.

./.

Des weiteren ist vorgesehen, daß jedem der Oszillatoren ein Tiefpaß vorgeschaltet ist und daß der dem zweiten Hall-Generator zugeordnete Oszillator spannungsgesteuert und daß diesem ein Gleichrichter zugeordnet ist. Außerdem sollte an die den Tiefpaß des zweiten Hall-Generators mit dem nachgeschalteten Gleichrichter verbindende Stromleitung ein Komparator und an diesen eine Anzeige für kapazitive und induktive Last angeschlossen sein.

In dem die Ausgangsspannung des Blindleistungs-Hall-Generators nach Tiefpaßfiltering einem Komparator zugeführt wird, der das Vorzeichen ermittelt, wird somit zwischen kapazitiver und induktiver Blindleistung unterschieden. Anschließend folgt der ideale Gleichrichter, der den Betrag bildet und somit stets eine positive Spannung an den Oszillator für Blindleistung liefert.

Angebracht ist es ferner, auch zwischen dem dem zweiten Hall-Generator zugeordneten Oszillator und der Recheneinheit einen Frequenzteiler einzuschalten, an dessen Ausgang Impulse auftreten, die jeweils einer bestimmten Blindenergiemenge entsprechen und die von der Recheneinheit aufsummierbar sind, und an die Recheneinheit einen von dieser steuerbaren Umschalter anzuschließen, mittels dem wechselweise jeweils ein Meßzweig mit den Hall-Generatoren mit der Recheneinheit verbindbar ist, derart, daß dieser Frequenzen zugeführt werden, die der Wirkleistung und der Blindleistung des Verbrauchers entsprechen. Außerdem sollte die Recheneinheit mittels zugeordneter Schalter zur Anzeige der Leistungs- oder der Verbrauchswerte des Verbrauchers umschaltbar sein.

Auf diese Weise können je nach Wahl der Oszillatorfrequenzen und der Teilerfaktoren Impulsfolgen an den Teilerausgängen erhalten werden, bei denen jeder Impuls dem Verbrauch von 1/1oo kWh bzw. 1/1oo kvar h entspricht.

./.

Die durch einen Faktor geteilten Oszillatorfrequenzen werden der Recheneinheit zugeführt und inkrementieren dort den Wirk- bzw. den Blindenergiezähler. Ferner erhält die Recheneinheit über eine Auswahllogik, die von den Bedienungstasten Leistung/Energie und Wirk/Blind gesteuert wird, die Ausgangsfrequenz des Wirkleistungs-Oszillators bzw. die Ausgangsfrequenz des Blindleistungs-Oszillators.

Ferner sollten zur Stromversorgung der elektrischen Funktionselemente diese vorzugsweise über eine zentrale Stromversorgungseinrichtung an den zu messenden Stromkreis angeschlossen werden.

Auch sollte eine durch die Recheneinheit betätigbare Einrichtung zur Abschaltung des Verbrauchers vorhanden sein.

Die elektrischen Funktionselemente des Meßgerätes sind zweckmäßigerweise in einem Gehäuse einzusetzen, das mittels integrierter Steckverbindungen oder mittels Steckverbindungen, die mit dem Gehäuse durch Leitungen verbuden sind, in den Meßkreis einschaltbar ist.

In der Zeichnung sind zwei Ausführungsbeispiele des erfindungsgemäß ausgebildeten Meßgerätes dargestellt, die nachfolgend im einzelnen erläutert sind. Hierbei zeigen:

Fig. 1    ein Meßgerät zur Bestimmung der Leistung und des Energieverbrauches eines Verbrauchers und

Fig. 2    ein Meßgerät zur wahlweisen Bestimmung aller kennzeichnenden Leistungsgrößen eines Wechselstromverbrauchers.

./.

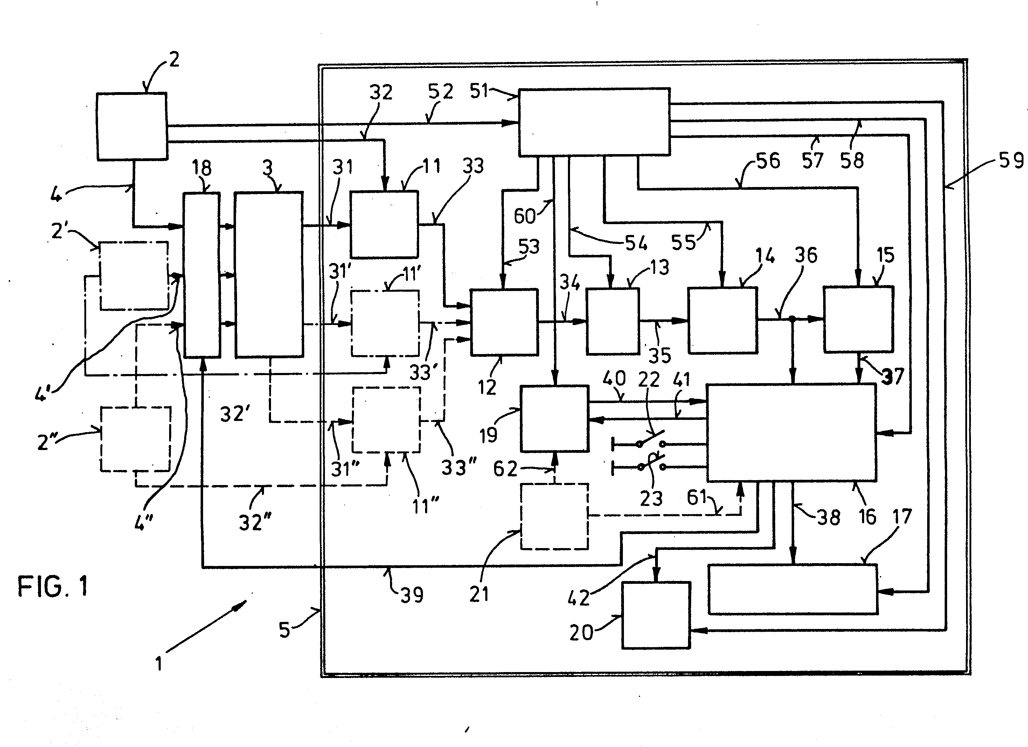

Das in Fig. 1 mit 1 bezeichnete Meßgerät zur gleichzeitigen Messung der momentanen Leistungsaufnahme und des Energieverbrauchs eines Verbrauchers 3 besteht im wesentlichen aus einem über Stromleitungen 31 und 32 an dessen Stromquelle 2 angeschlossenen Meßwertaufnehmer 11, einem spannungsgesteuerten Oszillator 14 und einer Recheneinheit 16 zur Auswertung der Ausgangsfrequenz des spannungsgesteuerten Oszillators 14. Dem spannungsgesteuerten Oszillator 14 ist hierbei ein Verstärker 13 vorgeschaltet, außerdem ist an diesen ein Frequenzteiler 15 angeschlossen. An die Recheneinheit 16 ist des weiteren eine Anzeigeeinheit 17 angeschlossen.

Werden, wie dies strichpunktiert eingezeichnet ist, bei Speisung des Verbrauchers 3 an mehreren Gleich- oder Wechselstromquellen oder aus einem n-phasigen Wechselstromsystem (n = 1,2,3...) zusätzliche weitere Meßwertaufnehmer 11' und 11'', die über Stromleitungen 32' und 32'' mit den einzelnen Stromquellen 2' bzw. 2'' und über Stromleitungen 31' bzw. 31'' mit dem Verbraucher 3 verbunden sind, vorgesehen, so ist zwischen dem Verstärker 13 und den Meßwertaufnehmern 11, 11' und 11'' eine Summierungseinrichtung 12 einzusetzen, die über Signalleitungen 33, 33' und 33'' mit den Meßwertaufnehmern 11, 11' und 11'' verbunden ist.

Zur Stromversorgung der in einem Gehäuse 5 eingesetzten und über Signalleitungen 34, 35, 36, 37 und 38 aneinander angeschlossenen elektrischen Funktionselementen, nämlich der Summierungseinrichtung 12, des Verstärkers 13, des spannungsgesteuerten Oszillators 14, des Frequenzteilers 15 sowie der Recheneinheit 16 und der Anzeigeeinheit 17 ist eine Stromversorgungseinrichtung 51 vorgesehen, die über

./.

eine Stromleitung 52 mit der Stromquelle 2 und über Stromleitungen 53, 54, 55, 56, 57 und 58 mit diesen in Verbindung steht. Des weiteren ist die Stromversorgungseinrichtung 51 über eine Leitung 59 mit einer der Recheneinheit 16 zugeordneten Signaleinrichtung 2o, die mit dieser über eine Signalleitung 42 in Verbindung steht, und über eine Leitung 6o mit einer Zeitschalteinrichtung 19, die über Signalleitungen 4o und 41 an die Recheneinheit 16 angeschlossen ist, verbunden.

Des weiteren ist die Recheneinheit 16 mit einer bei Ausfall des zu messenden Stromkreises zuschaltbaren strichliniert eingezeichneten Stromquelle 21, die über Stromleitungen 61 und 62 mit dieser und der Zeitschaltienrichtung 19 in Verbindung steht, versehen. In die zu dem Verbraucher 3 führenden Stromleitungen 4, 4' und 4'' ist ferner eine Abschalteinrichtung 18 eingesetzt, die über eine Signalleitung 39 an die Recheneinheit 16 angeschlossen ist. Die Recheneinheit 16 ist ferner mit zwei Tasten 22 und 23 für das Rücksetzen des Energieverbrauchszählers und das Auslösen der Leistungsanzeige ausgestattet. Selbstverständlich ist die Abschalteinrichtung 18 ebenfalls innerhalb des Gehäuses 5 angeordnet, zum einfacheren Verständnis aber vor diesem dargestellt.

Durch den Anschluß des einen Hallgenerator enthaltenden Meßwertaufnehmers 11 über die Leitung 31 an den Verbraucher 3 und über die Leitung 32 an dessen Stromquelle 2 wird in diesem in Abhängigkeit von dem leistungsbestimmenden Strom ein magnetisches Induktionsfeld erzeugt. Dieses Induktionsfeld hängt somit ab vom dem Strom, der zum Verbraucher 3 fließt. Außerdem fließt durch den Strompfad des Hallgenerators ein Strom, der phasengleich und

./.

proportional der Spannung ist, die den Verbraucherstrom bestimmt. Der Meßwertaufnehmer 11 bildet somit als Ausgangssignal das Produkt aus dem magnetischen Induktionsfeld, das hervorgerufen wird durch den Verbraucherstrom und den Steuerstrom.

Die Ausgangsspannung des Meßwertaufnehmers 11 wird über die Signalleitung 34 dem Verstärker 13 zugeleitet und in diesem wird der Mittelwert der Spannung gebildet und über die Signalleitung 35 dem spannungsgesteuerten Oszillator 14 zugeführt. Dieser setzt die Steuerspannung um in ein Ausgangssignal mit einer Frequenz, die proportional der Eingangsspannung ist. Der dem spannungsgesteuerten Oszillator 14 sowie der Recheneinheit 16 zugeordnete Frequenzteiler 15 teilt hierbei mit einem geeigneten wählbaren Teilerverhältnis die Frequenz soweit herunter, daß an dessen Ausgang jeder Impuls den Verbrauch von z. B. 1/100 kWh darstellt.

In der Recheneinheit 16 werden diese Impulse einem Zähler zugeführt, dessen Stand in der Anzeige 17 wiedergegeben werden kann und ein Maß für die verbrauchte Energie ist. Ferner können in der Recheneinheit 16 die Schwingungen als Ausgangssignal des spannungsgesteuerten Oszillators 14 über eine definierte Zeit, z. B. 1 Sec. gezählt werden, wobei der Zählerstand von Null beginnend nach Ablauf dieser Zeit der Leistungsaufnahme des Verbrauchers entspricht und in der Anzeige 17 wiedergegeben werden kann.

Mittels der dem Rechenwerk 16 des weiteren zugeordneten Einrichtungen, nämlich der Zeitschalteinrichtung 19, der Signaleinrichtung 2o sowie der netzunabhängigen Stromquelle 21 ist dieses entsprechend der Funktion dieser Einrichtungen beeinflußbar. Außerdem kann mit Hilfe der Abschalteinrichtung 18, die von der Recheneinheit 16 ausgelöst werden kann, die Stromversorgung des Verbrauchers 3 unterbrochen werden.

.⁄.

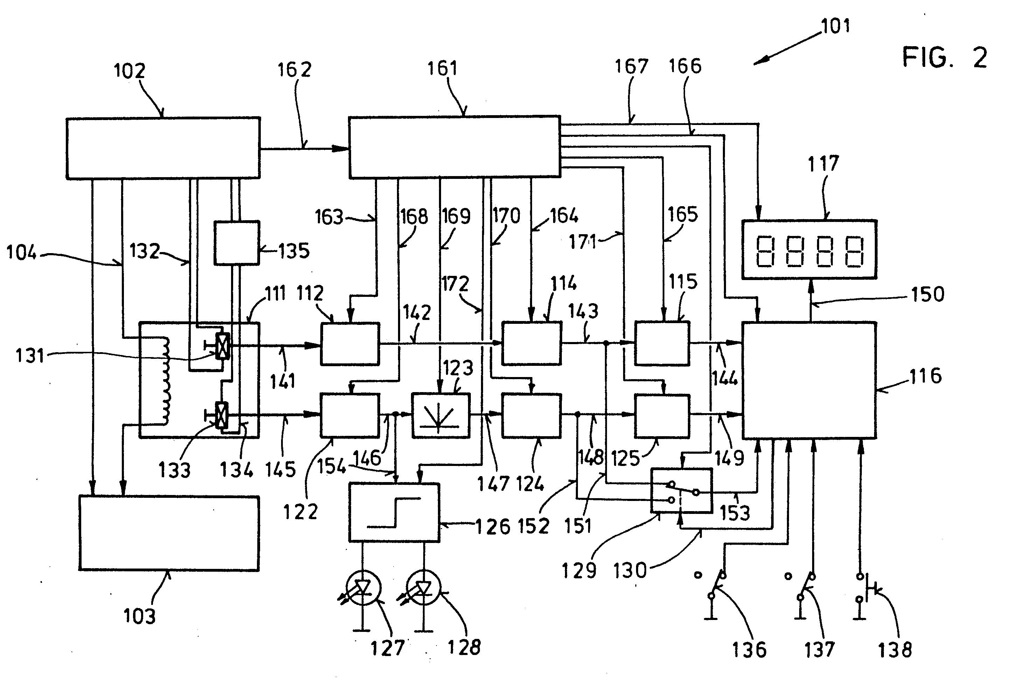

Das in Fig. 2 dargestellte Meßgerät 1o1 dient zur wahlweisen Bestimmung aller kennzeichnenden Leistungsgrößen eines Wechselstromverbrauchers 1o3 und besteht im wesentlichen aus einem in die Stromzuführungsleitung 1o4 des Verbrauchers 1o3, mittels der dieser an eine Stromquelle 1o2 angeschlossen ist, eingesetzten Meßwertaufnehmers 111, der mit zwei Hall-Generatoren 131 und 133 bestückt ist, deren Meßwerte über zwei unterschiedliche mit Oszillatoren 114 bzw. 124 versehene Leistungsmeßzweige einer Recheneinheit 116 zuführbar sind.

Der erste Leistungsmeßzweig wird durch den Hall-Generator 131 gebildet, der über eine Leitung 132 mit Steuerstrom versorgt wird und über eine Leitung 141 an einen Tiefpaß 112 angeschlossen ist, der über eine Leitung 142 mit dem spannungsgesteuerten Oszillator 114 verbunden ist. Über eine Leitung 143 steht der Oszillator 114 mit der Recheneinheit 116 in Verbindung, an die mittels einer Leitung 144 ein Frequenzteiler 115 angeschlossen und die mit einer Anzeigeeinheit 117 versehen ist.

Der zweite Leistungsmeßzweig besteht aus dem zweiten Hall-Generator 133, in dessen Steuerstromzuführungsleitung 134 ein Phasenschieber 135 eingeschaltet ist, einem über eine Leitung 145 an den Hall-Generator 133 angeschlossenen Tiefpaß 122, einem mit diesem über eine Leitung 146 verbundenen Gleichrichter 123 sowie dem ebenfalls spannungsgesteuerten Oszillator 124 und einem Frequenzteiler 125. Der Oszillator 124 ist hierbei über die Leitung 146 an den Gleichrichter 123 und über die Laitung 148 an den Frequenzteiler 125 angeschlossen, der über die Leitung 149 mit der Recheneinheit 116 in Verbindung steht. Des weiteren ist an die Leitung 146 über eine Leitung 154 ein Komparator 186 angeschlossen, der mit Anzeigen 127 und 128 für kapazitive bzw.

./.

induktive Last versehen ist. Der Recheneinheit 116 ist ferner ein Umschalter 129 zugeordnet, der über eine Leitung 13o mit dieser verbunden ist und durch die Recheneinheit 116 geschaltet wird. Zur Vermeidung von Fehlmessungen wird somit zu einem definierten Zeitpunkt eine Umschaltung vorgenommen.

Zur Stromversorgung der elektrischen Funktionselemente ist eine Stromversorgungseinrichtung 161 vorgesehen, die über eine Stromleitung 162 mit der Stromquelle 1o2 und über Stromleitungen 163, 164, 165, 166, 167, 168, 169, 17o, 171 und 172 mit diesen einzeln verbunden ist. Des weiteren ist die Anzeigeeinheit 117 über eine Leitung 15o an die Recheneinheit 116 und der Umschalter 129 über Leitungen 151 und 152 an die Leitungen 143 bzw. 148 der beiden Leistungszweige sowie eine Leitung 153 an die Recheneinheit 116 angeschlossen. Mit Hilfe von Schaltern 136 und 137 ist die Recheneinheit 116, die auch eine Rückstelltaste 138 aufweist, auf einen der beiden Leistungsmeßzweige umschaltbar.

Mittels der Funktionselemente des ersten Leistungsmeßzweiges sind die Wirkleistungsaufnahme und der Wirkenergie- verbrauch des Verbrauchers 1o3 zu bestimmen. Um aber wahlweise die Wirkleistung oder die Blindleistung oder die verbrauchte Wirkenergie oder die verbrauchte Blindenergie anzuzeigen, ist zusätzlich der zweite Leistungsmeßzweig vorgesehen. Die Wirk- und Blindenergie werden dabei ständig aufintegriert, unabhängig davon, welche Größe jeweils angezeigt wird.

Das Meßgerät 1o1 ermöglicht somit die Messung der Wirk- und Blindleistung des Verbrauchers 1o3 und summiert gleich- zeitig den Wirk- und Blindenergieverbrauch auf. Diese vier Größen sind wahlweise anzeigbar. Bei der Blindleistung wird

./.

kapazitive und induktive Blindleistung unterschieden.
Mit den genannten Meßgrößen hat man alle kennzeichnenden
Leistungsgrößen eines Wechselstromverbrauchers zur Verfügung bzw. man kann sie auf einfache Weise aus den Meßgrößen berechnen.

Die Wirkleistung P, die ein Verbraucher aufnimmt, kann
beispielsweise entsprechend der Ausgestaltung gemäß
Figur 1 bestimmt werden, indem man dem Hall-
Generator 131 einem dem leistungsbestimmenden Strom entsprechenden magnetischen Induktionsfeld aussetzt, wobei
der Hall-Generator 131 einen der leistungsbestimmenden
Spannung entsprechenden Steuerstrom erhält. Der Mittelwert
(Gleichanteil) der von dem Hall-Generator 131 gelieferten
Hallspannung ist dann proportional zur Wirkleistung des
Verbrauchers 1o3. Der Gleichanteil der Hallspannung wird
in dem spannungsgesteuerten Oszillator 114 in eine geneigte Frequenz umgewandelt, die in der Recheneinheit 116
ausgewertet wird.

Der zweite Hall-Generator 133 wird nun zusätzlich dem
gleichen magnetischen Induktionsfeld ausgesetzt wie der
erste Hall-Generator 131, erhält aber einen Steuerstrom,
der amplitudenproportional und um 90$^{\circ}$ phasenverschoben
gegenüber der leistungsbestimmenden Spannung ist. Der
Mittelwert (Gleichanteil) der Hallspannung des zweiten
Hall-Generators 133 ist dann proportional zur Blindleistung
des Verbrauchers 1o3 und das Vorzeichen des Gleichanteils
kann in diesem Fall zur Unterscheidung von kapazitiver und
induktiver Blindleistung herangezogen werden. Zu diesem
Zweck ist der Komparator 126 vorgesehen,der eines der
Anzeigeelemente 127 und 128 ansteuert, je nachdem, ob
der Gleichanteil der Hallspannung des zweiten Hall-
Generators 133 positiv oder negativ ist. Der Gleichrichter

./.

123 bildet den Betrag der der Blindleistung entsprechenden Spannung und führt sie dem spannungsgesteuerten Oszillator 124 zu, wo sie in eine entsprechende, geeignete Frequenz umgewandelt wird, die dann zur Ermittlung der Blindleistung und Blindenergie mit Hilfe des Frequenzteilers 123 und der Recheneinheit 116 ausgewertet wird.

Die Bildung des Betrages der der Blindleistung entsprechenden Spannung ist zweckmäßig, da kapazitive und induktive Blindleistung das Stromnetz gleichermaßen belasten und zu Verlusten führen. Somit ist nur die betragsmäßige Aufsummierung der Blindenergie für sinnvolle Aussagen über die Netzbelastung durch Blindverbraucher geeignet. Die Information über das Vorzeichen der Blindleistung geht in dem Meßgerät 101 nicht verloren, da der Komparator 126 es zur Anzeige bringt. Der Betrag der Blindleistung wird von der Recheneinheit 116 ermittelt, wenn der Umschalter 129 die Signalleitungen 152 und 153 miteinander verbindet, indem für eine fest vorgegebene Zeit die Schwingungen am Ausgang des spannungsgesteuerten Oszillators 124 von der Recheneinheit 116 gezählt werden. Die Blindenergie wird ermittelt, indem die Recheneinheit 116 ständig die Ausgangsimpulse des Frequenzteilers 125 aufsummiert, der die Frequenz des Oszillators 124 herunterteilt. In analoger Weise werden auch Wirkleistung und Wirkenergie aus der Ausgangsfrequenz des spannungsgesteuerten Oszillators 114 mit Hilfe des Frequenzteilers 115 und der Recheneinheit 116 ermittelt. Zur Wirkleistungsmessung verbindet der Umschalter 129 die Signalleitungen 151 und 153. Die Wirkenergiemessung erfolgt durch ständiges Aufsummieren der Ausgangsimpulse des Frequenzteilers 115 in der Recheneinheit 116.

./.

Mit Hilfe der Schalter 136 und 137 kann jeweils eine der Meßgrößen, nämlich Wirkleistung, Blindleistung, Wirkenergie oder Blindenergie in die Anzeige 117 gebracht werden. Zur Wirk- und Blindleistungsmessung wird der Umschalter 129 von der Recheneinheit 116 zeitrichtig so betätigt, daß zu Beginn der festgelegten Meßzeit der jeweils ausgewählte Oszillatorausgang über die Leitung 153 mit der Recheneinheit 116 verbunden ist.

9. November 1983    e-1
A 6653/54 EP

Rafi GmbH & Co
Elektrotechnische Spezialfabrik

7981 Berg bei Ravensburg

P a t e n t a n s p r ü c h e :

1. Meßgerät zur Bestimmung der Leistungsaufnahme und des Energieverbrauches eines Verbrauchers elektrischer Energie,

d a d u r c h   g e k e n n z e i c h n e t ,

daß in den Stromkreis des Verbrauchers (3) ein einen Hallgenerator enthaltender eine Ausgangsspannung als Produkt aus Spannung und Strom erzeugender Meßwertaufnehmer (11) einschaltbar ist, in dem in Abhängigkeit von dem leistungsbestimmenden Strom ein magnetisches Induktionsfeld am Ort des Hallgenerators erzeugbar ist, wobei der Hallgenerator einen der leistungsbestimmenden Spannung entsprechenden Steuerstrom erhält, daß an dem Meßwertaufnehmer (11) ein spannungsgesteuerter Oszillator (14) angeschlossen ist, dem als Steuerspannung die Ausgangsspannung des Hallgenerators zuführbar ist, und daß der Oszillator (14) mit einer Recheneinheit (16) zur Auswertung der Ausgangsfrequenz verbunden ist.

./.

2. Meßgerät nach Anspruch 1,

d a d u r c h   g e k e n n z e i c h n e t ,

daß bei Gleichstromsystemen oder n-phasigen Wechselstromsystemen den Hallgeneratoren der Messwertaufnehmer (11,
11', 11'') eine Summierungseinrichtung (12) nachgeschaltet ist, deren Summensignal dem spannungsgesteuerten
Oszillator (14) als Steuerspannung zuführbar ist.

3. Meßgerät nach Anspruch 1 oder 2,

d a d u r c h   g e k e n n z e i c h n e t ,

daß dem spannungsgesteuerten Oszillator (14) ein Verstärker (13) vorgeschaltet ist.

4. Meßgerät nach einem oder mehreren der
Ansprüche 1 bis 3,

d a d u r c h   g e k e n n z e i c h n e t ,

daß an den spannungsgesteuerten Oszillator (14) ein Frequenzteiler (15) angeschlossen ist, der mit der Recheneinheit (16) in Verbindung steht.

5. Meßgerät nach einem oder mehreren der
Ansprüche 1 bis 4,

d a d u r c h   g   e k e n n z e i c h n e t ,

daß ein Teil der Recheneinheit (16) als elektronischer löschbarer Impulszähler ausgebildet ist, mittels dem die Schwingungszahl des spannungsgesteuerten Oszillators (14) aufsummierbar und dessen Zählerstand ein Maß für die verbrauchte
Energie ist.

./.

- 3 -

6. Meßgerät nach Anspruch 5,

   d a d u r c h   g e k e n n z e i c h n e t ,

   daß ein Zähler in der Recheneinheit (16) mittels einer
   zugeordneten Rücksetzeinrichtung periodisch löschbar ist,
   wobei der Zählerstand unmittelbar vor dem Löschvorgang
   ein Maß für die Leistungsaufnahme des Verbrauchers (3)
   ist.

7. Meßgerät nach einem oder mehreren der
   Ansprüche 1 bis 6,

   d a d u r c h   g e k e n n z e i c h n e t ,

   daß die Recheneinheit (16) mit einer Anzeigeeinheit (17)
   zur Darstellung der jeweiligen Zählerstände versehen ist.

8. Meßgerät nach einem oder mehreren der
   Ansprüche 1 bis 7,

   d a d u r c h   g e k e n n z e i c h n e t ,

   daß als Recheneinheit (16) ein Mikroprozessor vorgesehen
   ist.

9. Meßgerät nach einem oder mehreren der
   Ansprüche 1 bis 7,

   d a d u r c h   g e k e n n z e i c h n e t ,

   daß die Recheneinheit (16) teilweise in Form mechanischer
   Zähler ausgebildet ist.

1o. Meßgerät nach einem oder mehreren der
    Ansprüche 1 bis 9,

    d a d u r c h   g e k e n n z e i c h n e t ,

    daß die Recheneinheit (16) mit einer bei Ausfall des zu
    messenden Stromkreises selbsttätig zuschaltbaren unabhängigen Stromquelle (21) versehen ist.

./.

C109644

11. Meßgerät nach einem oder mehreren der
Ansprüche 1 bis 1o,

d a d u r c h   g e k e n n z e i c h n e t ,

daß die Recheneinheit (16) mit einer Zeitschalteinrichtung (19) versehen ist.

12. Meßgerät nach einem oder mehreren der
Ansprüche  1 bis 11,

d a d u r c h   g e k e n n z e i c h n e t ,

daß die Recheneinheit (16) mit einer elektrischen,
optischen oder akustischen, vorzugsweise einstellbaren
Signaleinrichtung (2o) versehen ist.

13. Meßgerät nach einem oder mehreren der
Ansprüche 1 bis 12,

d a d u r c h   g e k e n n z e i c h n e t ,

daß zur wahlweisen Bestimmung aller kennzeichnenden
Leistungsgrößen eines Wechselstromverbrauchers (1o3) der
Meßwertaufnehmer (111) mit einem zweiten Hall-Generator
(133) versehen ist, der dem gleichen Magnetfeld wie der
erste Hall-Generator (131) ausgesetzt ist und der einen
Steuerstrom erhält, der mittels eines Phasenschiebers
(135) gegenüber der leistungsbestimmenden Spannung zur
Ermittlung der Blindleistung phasenverschoben ist, und
daß der zweite Hall-Generator (133) über einen weiteren
Oszillator (124) mit der Recheneinheit (116) verbunden ist.

./.

14. Meßgerät nach nach Anspruch 13,

d a d u r c h   g e k e n n z e i c h n e t ,

daß jedem der Oszillatoren (114, 124) ein Tiefpaß
(112 bzw. 122) vorgeschaltet ist.

15. Meßgerät nach Anspruch 13 oder 14,

daß der dem zweiten Hall-Generator (133) zugeordnete
Oszillator (124) spannungsgesteuert und daß diesem ein
Gleichrichter (123) vorgeschaltet ist.

16. Meßgerät nach einem oder mehreren der
Ansprüche 12 bis 15,

d a d u r c h   g e k e n n z e i c h n e t ,

daß an die den Tiefpaß (122) des zweiten Hall-Generators
(133) mit dem nachgeschalteten Gleichrichter (123) verbindende Stromleitung (146) ein Komparator (126) und an
diesen eine Anzeige (127, 128) für kapazitive und
induktive Last angeschlossen sind.

17. Meßgerät nach einem oder mehreren der
Ansprüche 13 bis 16,

d a d u r c h   g e k e n n z e i c h n e t ,

daß zwischen dem dem zweiten Hall-Generator (133)
zugeordneten Oszillator (124) und der Recheneinheit
(116) ein Frequenzteiler (125) eingeschaltet ist, an
dessen Ausgang Impulse auftreten, die jeweils einer
bestimmten Blindenergiemenge entsprechen und die von
der Recheneinheit (116) aufsummierbar sind.

./.

18. Meßgerät nach einem oder mehreren der
Ansprüche 13 bis 17,

d a d u r c h   g e k e n n z e i c h n e t ,

daß an die Recheneinheit (116) ein von dieser steuerbarer Umschalter (129) angeschlossen ist, mittels dem
wechselweise jeweils ein Meßzweig mit den Hall-
Generatoren (131 oder 133) mit der Recheneinheit (116)
verbindbar ist, derart, daß dieser Frequenzen zugeführt
werden, die der Wirkleistung der Blindleistung des
Verbrauchers (1o3) entsprechen.

19. Meßgerät nach einem oder mehreren der
Ansprüche 13 bis 18,

d a d u r c h   g e k e n n z e i c h n e t ,

daß die Recheneinheit (116) mittels zugeordneter Schalter
(136, 137) zur Anzeige der Leistungs- oder der Verbrauchswerte des Verbrauchers (1o3) umschaltbar ist.

2o. Meßgerät nach einem oder mehreren der
Ansprüche 1 bis 19,

d a d u r c h   g e k e n n z e i c h n e t ,

daß zur Stromversorgung der elektrischen Funktionselemente diese vorzugsweise über eine zentrale Stromversorgungseinrichtung (51; 161) an den zu messenden
Stromkreis angeschlossen sind.

21. Meßgerät nach einem oder mehreren der
Ansprüche 1 bis 2o,

d a d u r c h   g e k e n n z e i c h n e t ,

0109644

daß eine durch die Recheneinheit (16) betätigbare Einrichtung (18) zur Abschaltung des Verbrauchers (3) vorgesehen ist.

22. Meßgerät nach einem oder mehreren der Ansprüche 1 bis 21,

d a d u r c h   g e k e n n z e i c h n e t ,

daß die elektrischen Funktionselemente des Meßgerätes (1) in einem Gehäuse (5) eingesetzt sind, das mittels integrierter Steckverbindungen oder mittels Steckverbindungen, die mit dem Gehäuse (5) durch Leitungen verbunden sind, in den Meßkreis einschaltbar ist.

A 6653/54 EP        e-1
9. November 1983

FIG. 1

A6653/54

FIG. 2